# FASCICULE DE BREVET EUROPEEN

(11) **EP 1 968 117 B1**
(45) Date de publication et mention de la délivrance du brevet: **02.05.2012**
(21) Numéro de dépôt: 08102287.3
(22) Date de dépôt: 05.03.2008
(51) Int. Cl.: H01L 45/00, H01L 27/24

(54) **Dispositif de mémorisation de données multi-niveaux à matériau à changement de phase**
Vorrichtung zur mehrstufigen Datenspeicherung auf Material mit Phasenumwandlung
Device for multi-level data memorisation with phase-changing material

(30) Priorité: 09.03.2007 FR 0753739
(43) Date de publication de la demande: 10.09.2008
(73) Titulaire: Commissariat à l'Énergie Atomique et aux Énergies Alternatives, 75015 Paris (FR)
(72) Inventeur: Gidon, Serge, 38140 La Murette (FR)
(74) Mandataire: Ilgart, Jean-Christophe

(56) Documents cités:
- EP-A1- 1 376 594
- US-A1- 2003 206 453
- US-A1- 2004 151 024
- GIDON S ET AL: "Electrical probe storage using Joule heating in phase change media" APPLIED PHYSICS LETTERS, AIP, AMERICAN INSTITUTE OF PHYSICS, MELVILLE, NY, US, vol. 85, no. 26, 27 décembre 2004 (2004-12-27), pages 6392-6394, XP012063948 ISSN: 0003-6951

## Description

### DOMAINE TECHNIQUE ET ART ANTÉRIEUR

L'invention concerne le domaine de l'enregistrement de données, et plus particulièrement un dispositif de mémorisation de données multi-niveaux.

Dans le domaine de l'informatique, des capacités mémoires de plus en plus importantes sont nécessaires. Il existe plusieurs types de mémoire pour enregistrer des données : des mémoires de masse, par exemple un disque dur ou un disque optique, ou des mémoires dynamiques, par exemple une mémoire DRAM (mémoire à accès aléatoire dynamique) ou de type Flash. Les mémoires dynamiques sont également appelées « mémoires solides » dans la mesure où aucun élément mécanique mobile n'est utilisé.

Le document « 4-Mb MOSFET-Selected µTrench Phase-Change Memory Experimental Chip » de F. Bedeschi et al., IEEE J. Solid-State Circuits, vol. 40, n° 7, juillet 2005, décrit une mémoire à base d'un matériau à changement de phase (appelée également mémoire PC ram) dont le fonctionnement est basé sur une modification de l'état de cristallinité d'un volume du matériau à changement de phase (chalcogénure), enchâssé entre deux électrodes. Le passage d'une phase à l'autre, c'est-à-dire de l'état cristallin à l'état amorphe ou inversement, est obtenu par chauffage Joule, au moyen d'une impulsion de courant plus ou moins importante. L'état de la mémoire est détecté par lecture de la résistance du volume de matériau à changement de phase.

Toutefois, avec ce type de mémoire, les augmentations de la capacité de stockage sont liées uniquement à l'augmentation de la densité d'intégration surfacique des éléments de stockage, c'est à dire la réduction de la taille des éléments de stockage. De plus, afin d'accéder efficacement aux données, le bus d'accès doit être conçu pour minimiser les couplages électromagnétiques lors de l'adressage afin d'accepter des fréquences de fonctionnement toujours plus élevées pour avoir un temps d'accès court, ce qui pourrait poser des problèmes lors des évolutions ultérieures de l'intégration dans de telles mémoires.

Il existe également des mémoires dites « à micro-pointes », comportant un support de stockage adressé au moyen d'un réseau de micro-pointes mobiles. Ces micro-pointes modifient localement des propriétés physico-chimiques (par exemple mécanique, thermique ou électrique) de la surface du support de stockage pour y écrire des informations. Ces informations peuvent ensuite être lues par détection des modifications des propriétés physico-chimiques réalisées sur la surface du support. Dans ce type de mémoire, les extrémités des micro-pointes définissent la limite de la densité surfacique des éléments de stockage. La densité surfacique obtenue (par exemple de l'ordre de 0,15 Tbits/cm²) prédispose ces mémoires à des applications de grande capacité dans un petit volume, par exemple destinées à des dispositifs "nomades". Par ailleurs, leur technologie de fabrication ne nécessitant pas de moyens lithographiques avancés, leur coût de fabrication reste peu élevé.

Le document « The "Millipede" - More than one thousand tips for future AFM data storage » de P. Vettiger et al., IBM J. Res. Develop., vol. 44, n°3, mai 2000, pages 323 à 340, décrit une mémoire à micro-pointes mettant en oeuvre les techniques de la microscopie à force atomique (AFM) sur la surface d'une couche de stockage à base de matériaux polymères. Les informations stockées dans cette mémoire se présentent sous forme de trous réalisés dans la couche de stockage.

Mais là encore, les augmentations des capacités de stockage de telles mémoires à micro-pointes sont liées uniquement à l'augmentation de la densité d'intégration surfacique des éléments de stockage et à la réduction des dimensions des extrémités des micro-pointes. De plus, ce type de mémoire nécessite que la précision de repérage du MEMS pilotant les micro-pointes augmente proportionnellement à l'augmentation de la densité d'intégration surfacique des éléments de stockage, ce qui pourrait être un obstacle dans le futur.

Le document « Electrical probe storage using Joule heating in phase change media » de S. Gidon et al., Applied Physics Letters, vol. 85, n° 26, 27 décembre 2004, décrit une mémoire à micro-pointes utilisant un matériau à changement de phase. L'état de cristallisation est modifié par effet Joule (mode électrique) sur une zone du média désignée par une pointe. La lecture de l'état de cristallinité de la surface est réalisée par détection de la conduction locale. Toutefois, ce type de mémoire nécessite que la précision de repérage du MEMS pilotant les micro-pointes augmente proportionnellement à l'augmentation de la densité d'intégration surfacique des éléments de stockage, ce qui pourrait représenter un obstacle lors d'une augmentation de la capacité de stockage. De plus, ce type de mémoire n'est pas réversible, les données stockées ne pouvant être ensuite effacées.

### EXPOSÉ DE L'INVENTION

Un but de la présente invention est de proposer un dispositif dont la capacité de stockage ne soit pas liée uniquement à la densité d'intégration surfacique des éléments de stockage du dispositif et aux dimensions de la surface du dispositif de stockage.

Pour cela, la présente invention propose un dispositif de mémorisation de données, comportant au moins :
- un empilement de couches comportant au moins une couche mémoire à base d'un matériau à changement de phase disposée entre au moins deux couches isolantes, disposé sur un substrat,
- une pluralité de colonnes disposées dans l'empilement de couches, et traversant chaque couche de cet empilement, chacune des colonnes étant à base d'au moins un matériau électriquement conducteur.

Ainsi, on utilise un support de mémorisation constitué de multiples niveaux mémoire. Un élément de mémorisation est formé à chaque intersection d'une colonne avec une couche mémoire de l'empilement.

On réalise une intégration tridimensionnelle des circuits de stockage avec un empilement des zones mémoires, permettant que l'augmentation de la capacité de stockage ne soit plus uniquement liée à l'augmentation de la densité d'intégration surfacique des éléments de stockage du dispositif.

Il est donc possible d'obtenir avec un tel dispositif de très grandes capacités de stockage à faible coût, dans un volume réduit, sans étendre la surface de chaque couche mémoire. Cette architecture de mémoire multi-niveaux à base d'un matériau à changement de phase peut s'adapter pour former une mémoire à micro-pointes ou une mémoire solide.

De plus, un tel dispositif de mémorisation a notamment pour avantage de pouvoir continuer de fonctionner même si une ou plusieurs des couches mémoires devenaient défaillantes, grâce aux autres couches mémoires.

Enfin, contrairement à une structure PCRAM classique dans laquelle les plots de contact sont généralement circulaires, la structure en colonnes traversant les couches d'un tel dispositif permet d'obtenir des zones de contact par exemple de forme cylindrique, entre les colonnes et les couches mémoires, de plus faibles surfaces, induisant ainsi une plus forte densité de courant au niveau de ces surfaces de contact. Une telle densité de courant est favorable à un échauffement localisé permettant au matériau d'une portion de la couche mémoire se trouvant autour d'une colonne de changer de phase.

Par exemple, dans le cas de colonnes comportant des sections formant des disques de rayon r, la surface de contact entre une des colonnes et une des couches mémoires d'épaisseur e peut être égale à 2×π×*r*×*e*.

Cette surface est bien inférieure à la surface d'un plot de contact d'une structure PCRAM classique qui est égale à *π*×*r²* quand l'épaisseur e est inférieure à r/2, ce qui est aisément obtenu avec des couche d'épaisseur e nanométrique, typiquement égale à environ 3 nm, et des rayons r au moins égales à 10 nm.

Le dispositif peut comporter une pluralité d'éléments de mémorisation formés par des portions annulaires de la couche mémoire entourant les colonnes.

Le dispositif peut comporter des diodes disposées entre chaque couche mémoire et chacune des colonnes.

Le dispositif peut comporter en outre des diodes disposées dans les colonnes, au niveau des couches isolantes.

L'empilement de couches peut être formé par une alternance de couches isolantes et de couches mémoires.

Le dispositif peut comporter une pluralité de tranchées réalisées dans l'empilement et traversant toutes les couches de l'empilement, formant plusieurs portions, isolées les unes des autres, de l'empilement de couches et des colonnes.

Chacune des couches mémoires peut être formée de plusieurs parties isolées électriquement les unes des autres.

Le dispositif peut comporter en outre des moyens d'application de tension aux bornes des colonnes. Ces moyens d'application de tension aux bornes des colonnes peuvent comporter un réseau de micro-pointes mobiles et/ou un réseau de lignes conductrices en contact avec les colonnes et/ou un réseau de transistors et/ou un circuit de multiplexage.

Le dispositif peut comporter en outre des moyens d'application de tension aux bornes des couches mémoires, et/ou des moyens de sélection d'une ou plusieurs colonnes et/ou des moyens de sélection d'une ou plusieurs couches mémoires.

Les moyens de sélection d'une ou plusieurs colonnes, et/ou les moyens de sélection d'une ou plusieurs couches mémoires peuvent être mis en oeuvre par un circuit électronique de multiplexage.

Le dispositif peut comporter des moyens de mesure de courant, tel un courant destiné à circuler dans les colonnes et/ou les couches mémoires, et/ou des moyens logiques de sélection d'adresse tels qu'un multiplexeur. Les moyens de mesure de courant peuvent comporter au moins un amplificateur intégré et/ou un convertisseur courant / tension et/ou un comparateur à seuil et/ou un convertisseur charge / tension (c'est-à-dire un intégrateur).

Les sections des colonnes, dans un plan sensiblement parallèle au plan principal de la couche mémoire, peuvent être rectangulaire, ou triangulaire, ou en forme de disque.

La présente invention concerne également un procédé de réalisation d'un dispositif de mémorisation de données, comportant au moins les étapes de :
- réalisation, sur un substrat, d'un empilement de couches comportant au moins une couche mémoire à base d'un matériau à changement de phase disposée entre au moins deux couches isolantes,
- gravure d'une pluralité de trous dans l'empilement de couches, les trous traversant chaque couche de l'empilement,
- réalisation de colonnes à base d'au moins un matériau électriquement conducteur, dans les trous tel qu'une pluralité d'éléments de mémorisation formés par des portions annulaires de la couche mémoire entourent les colonnes.

L'étape de réalisation des colonnes peut être telle qu'une pluralité d'éléments de mémorisation formés par des portions annulaires de la couche mémoire peuvent entourer les colonnes.

Le substrat peut comporter un circuit intégré comprenant des moyens de mesure de courant et/ou des moyens d'adressage des colonnes et des couches mémoires et/ou des moyens de multiplexage et/ou des moyens de sélection d'adresse.

La présente invention concerne également un procédé de réalisation d'un dispositif de mémorisation de données, comportant au moins les étapes de :
- réalisation, sur un substrat, de colonnes à base d'au moins un matériau électriquement conducteur,
- réalisation d'un empilement de couches comportant au moins une couche mémoire à base d'un matériau à changement de phase disposée entre au moins deux couches isolantes, sur le substrat, autour des colonnes tel qu'une pluralité d'éléments de mémorisation formés par des portions annulaires de la couche mémoire entourent les colonnes.

L'étape de réalisation de l'empilement de couches peut être telle qu'une pluralité d'éléments de mémorisation formés par des portions annulaires de la couche mémoire peuvent entourer les colonnes.

Le procédé peut comporter, avant l'étape de réalisation de l'empilement de couches ou avant l'étape de réalisation des colonnes, une étape de réalisation, sur le substrat, de moyens de mesure de courant, et/ou de moyens d'application de tension aux bornes des colonnes tels qu'un réseau de lignes conductrices en contact avec les colonnes ou destinées à être en contact avec les colonnes et/ou un réseau de transistors.

La réalisation de l'empilement de couches peut être obtenue par des étapes de dépôt alternées des couches isolantes et des couches mémoires, une étape supplémentaire de photolithographie et de gravure pouvant être mise en oeuvre après chaque dépôt d'une couche mémoire pour former plusieurs parties isolées électriquement les unes des autres de cette couche mémoire.

Le procédé peut comporter, entre l'étape de réalisation de l'empilement de couches et l'étape de réalisation des colonnes ou après l'étape de réalisation de l'empilement de couches, une étape de réalisation d'une pluralité de tranchées dans l'empilement, traversant toutes les couches de l'empilement et formant plusieurs portions, isolées les unes des autres, de l'empilement de couches.

Le procédé peut comporter en outre, par exemple entre l'étape de gravure de la pluralité de trous dans l'empilement de couches et l'étape de réalisation des colonnes, une étape de réalisation de diodes, sur les parois des trous ou autour des colonnes, au niveau de chaque couche mémoire. Chaque diode peut être destinée à être disposée au niveau d'une couche mémoire.

La réalisation des colonnes peut être obtenue par dépôt électrochimique et/ou par croissance de nanotubes ou de nanofils à partir d'un catalyseur déposé au préalable dans les trous ou sur le substrat.

Le procédé peut comporter, par exemple après la réalisation des colonnes, une étape de dépôt d'une couche au moins partiellement conductrice sur l'empilement et sur les colonnes ou au moins sur les colonnes.

Le procédé peut comporter en outre une étape de réalisation de diodes, dans les colonnes, au niveau des couches isolantes, ou autour des colonnes, chaque diode étant alors destinée à être disposée au niveau d'une couche mémoire.

Le procédé peut comporter une étape de réalisation d'un réseau de micro-pointes mobiles destinées à appliquer une tension aux bornes des colonnes.

Enfin, le procédé peut comporter une étape de réalisation de moyens de sélection d'une ou plusieurs colonnes et/ou une étape de réalisation de moyens de sélection d'une ou plusieurs couches mémoires.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1A et 1B représentent une vue en coupe d'une partie d'un dispositif de mémorisation, objet de la présente invention, selon deux variantes d'un premier mode de réalisation,
- les figures 2A et 2B représentent des vues en coupe, selon des plans perpendiculaires l'un par rapport à l'autre, d'un dispositif de mémorisation, objet de la présente invention, selon un second mode de réalisation,
- les figures 3A et 3B représentent des vues en coupe, selon des plans perpendiculaires l'un par rapport à l'autre, d'un dispositif de mémorisation, objet de la présente invention, selon un troisième mode de réalisation,
- les figures 4A à 4E représentent les étapes d'un procédé de réalisation, également objet de la présente invention, d'un dispositif de mémorisation, selon un premier mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

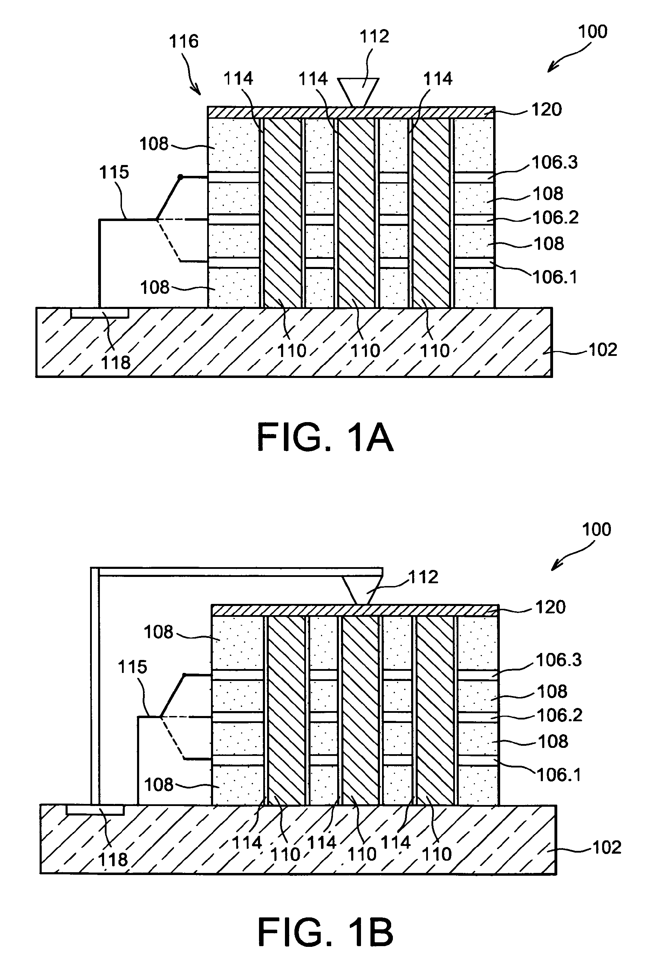

On se réfère tout d'abord à la figure 1A qui représente une vue en coupe d'une partie d'un dispositif de mémorisation de données 100 selon une première variante d'un premier mode de réalisation.

Le dispositif 100 comporte un substrat 102 par exemple à base de semi-conducteur tel que du silicium, et/ou de verre et/ou de plastique. Le substrat 102 peut également être à base de silicium d'orientation cristalline *(111)* ou *(100)*.

Le dispositif 100 comporte également plusieurs couches 106.1 à 106.3 à base d'un matériau à changement de phase, c'est-à-dire un matériau dont les propriétés de conduction électrique sont modifiables, empilées sur le substrat 102. Sur la figure 1A, seules trois couches 106.1 à 106.3 sont représentées. Ces couches 106.1 à 106.3 sont appelées « couches mémoires » et sont isolées à la fois mécaniquement et électriquement les unes des autres et du substrat 102 par des couches isolantes 108, ou couches diélectriques, à base d'un matériau tel que de la silice, et/ou du nitrure de silicium et/ou d'un mélange de sulfure de zinc et/ou d'oxyde de silicium, de faible conductivité thermique, et d'une épaisseur comprise entre environ 10 nanomètres et 300 nanomètres. Le dispositif 100 pourrait comporter un nombre différent de couches mémoires, par exemple huit couches mémoires. Les couches mémoires 106.1 à 106.3 peuvent par exemple être à base d'au moins un matériau de la famille des chalcogénures, par exemple du GeSe, et avantageusement des chalcogénures ternaires tels que du GeₓSb_{y}Te_{z} et/ou de l'AgₓIn_{y}Sb_{z}Teₜ, et/ou du silicium amorphe hydrogéné. Lors de la réalisation du dispositif 100, le matériau des couches mémoires 106.1 à 106.3 peut être en phase cristalline. Les couches mémoires 106.1 à 106.3 peuvent par exemple avoir une épaisseur comprise entre environ 1 nanomètres et 30 nanomètres, et avantageusement comprise entre environ 2 nm et 10 nm, et en particulier comprise entre environ 3 nm et 5 nm. Notamment, lorsque le matériau des couches mémoires 106.1 à 106.3 est de la famille des chalcogénures, le choix de l'épaisseur des couches mémoires est réalisé en faisant un compromis entre la nécessité de réduire l'épaisseur pour accroître le confinement des lignes de courant et le fait d'avoir une épaisseur suffisante pour que le matériau puisse changer d'état.

Dans ce premier mode de réalisation, chaque couche mémoire 106.1 à 106.3 est disposée entre deux couches isolantes 108. De manière générale, le dispositif 100 peut comporter au moins une couche mémoire disposée entre deux couches isolantes. Lorsque le dispositif 100 comporte plusieurs couches mémoires, chaque couche mémoire est disposée entre deux couches isolantes.

Le dispositif 100 comporte également plusieurs colonnes 110 au moins en partie à base d'un matériau électriquement conducteur tel que du Cu, et/ou du TiN, et/ou du W et/ou du Si dopé. Ces colonnes 110 traversent, par exemple perpendiculairement, les couches mémoires 106.1 à 106.3 et les couches isolantes 108. Sur la figure 1A, seules trois colonnes 110 sont représentées. Ces colonnes 110 peuvent par exemple avoir une forme sensiblement cylindrique et être de dimensions sensiblement similaires les unes par rapport aux autres. Ces colonnes 110 peuvent également être à base de nanotubes de carbone et/ou de semi-conducteur tel que du silicium par exemple sous forme de nanofils. Sur l'exemple de la figure 1A, les colonnes 110 sont régulièrement espacées les unes des autres, par exemple d'une distance comprise entre environ 22 nm et 66 nm. Les colonnes 110 ont par exemple une section circulaire de diamètre égal à environ 20 nm. Il est également possible que la section des colonnes soit de forme différente, par exemple rectangulaire, triangulaire, ou d'une toute autre forme.

Une structure de diodes électroniques 114 est formée autour de chaque colonne 110. Cette structure forme, entre chaque couche mémoire et la colonne autour de laquelle se trouve la structure, une diode électronique. Ainsi, une telle structure se trouvant autour d'une des colonnes 110 empêche un courant circulant au niveau d'une des couches mémoires 106.1 à 106.3 de passer dans les autres couches mémoires 106.1 à 106.3 par l'intermédiaire de cette colonne 110. Dans une variante, des diodes peuvent être réalisées dans les colonnes 110, entre chaque niveau mémoire, c'est-à-dire au niveau des couches isolantes 108.

Chaque intersection d'une colonne 110 et d'une des couches mémoires 106.1 à 106.3 forme un élément de mémorisation du dispositif 100, dans lequel sont écrites et/ou lues des informations.

Les couches mémoires 106.1 à 106.3 et les couches isolantes 108 peuvent être structurées en plusieurs « caissons », ou portions, disposés sur le substrat 102, isolés les uns des autres par du vide et/ou un matériau isolant. Sur l'exemple de la figure 1A, un seul caisson 116 comportant les couches mémoires 106.1 à 106.3 et les couches isolantes 108 est représenté.

Le dispositif 100 comporte également une pluralité de micro-pointes 112, par exemple un réseau de micro-pointes mobiles, à base d'au moins un matériau électriquement conducteur permettant de sélectionner les colonnes 110 dans lesquelles des informations doivent être écrites et/ou lues en polarisant ces colonnes 110 par l'application d'une tension aux bornes de ces colonnes 110. Sur la figure 1A, seule une micro-pointe 112 est représentée. Le nombre de micro-pointes 112 peut par exemple correspondre au nombre de caissons 116 du dispositif 100. Les micro-pointes 112 peuvent par exemple être espacées les unes des autres d'une distance égale à environ 100 µm. Ce réseau de micro-pointes 112 peut être piloté par des moyens de sélection de colonnes, non représentés sur la figure 1A, choisissant la ou les colonnes 110 qui sont à polariser.

La structure en caissons des couches mémoires 106.1 à 106.3 et des couches isolantes 108 permet qu'un nombre limité de diodes 114 soient soumises à une polarisation en inverse lorsque l'on polarise l'une des colonnes 110 par l'application d'une tension sur cette colonne 110, par l'intermédiaire d'une micro-pointe 112, et empêche la génération d'un courant de fuite trop important. Chaque caisson 116 peut par exemple comporter entre environ 1000 et 1000000 de colonnes 110.

Le dispositif 100 de la figure 1A comporte également une couche au moins partiellement conductrice 120, appelée couche de « tribologie », par exemple à base de carbone pulvérisé rendu conducteur par la présence d'impuretés métalliques également pulvérisées, disposée sur l'empilement des couches mémoires 106.1 à 106.3 et des couches isolantes 108, et sur les sommets des colonnes 110. La couche 120 peut également être à base de carbure de silicium (SiC) et/ou de couches minces de carbone amorphe (DLC pour « Diamond Like Carbon » en anglais). Cette couche 120 a une épaisseur comprise entre environ 1 nm et 10 nm, de telle sorte que sa conductivité permette le passage d'un courant, au niveau d'une des colonnes 110, entre la face de la couche 120 qui n'est pas en contact avec l'empilement des couches mémoires 106.1 à 106.3 et des couches isolantes 108, et ladite colonne 110, sans court-circuiter les autres colonnes 110. La couche de tribologie 120 permet de réduire l'usure des micro-pointes 112 par rapport à un contact direct des micro-pointes 112 avec des colonnes 110. La conductivité de la couche 120 est, par exemple, comprise entre environ 0,1 (Ω. com)⁻¹ et 100 (Ω.cm)⁻¹. Dans une variante, la couche 120 peut également être une couche isolante, par exemple à base d'alumine, dont l'épaisseur, par exemple égale à environ 1 nm, est choisie de façon à obtenir un effet tunnel entre cette couche 120 et les colonnes 110. Enfin, la couche 120 peut également être à base d'un matériau organique conducteur tel que du polyaniline (PANI).

Le dispositif 100 comporte également des moyens de sélection 115 de couches mémoires 106.1 à 106.3, qui peuvent être associés à des moyens d'application de tension aux bornes des couches mémoires 106.1 à 106.3, tels qu'un circuit d'adressage, fixant par exemple le potentiel des couches mémoires 106.1 à 106.3 « non actives », c'est-à-dire les couches mémoires 106.1 à 106.3 dans lesquelles aucune information n'est destinée à être lue et/ou écrite. Ce potentiel peut par exemple être égale à celui appliqué par une micro-pointe 112 à l'une des colonnes 110, par exemple un potentiel nul. Le circuit d'adressage polarise l'une des couches mémoires 106.1 à 106.3 sélectionnée, dans laquelle des informations sont destinées à être lues et/ou écrites.

Le dispositif 100 comporte également des moyens 118 de mesure de courant, disposés au niveau du substrat 102. Sur l'exemple de la figure 1A, les moyens 118 de mesure de courant sont reliés aux moyens de sélection 115 de couches mémoires. Les moyens de mesure de courant 118 peuvent comporter des moyens logiques de sélection d'adresse tels qu'un multiplexeur, tenant compte de la structure en caissons des couches mémoire 106.1 à 106.3 et des couches isolantes 108. Les moyens 118 de mesure de courant peuvent comporter au moins un amplificateur intégré et un convertisseur courant / tension, un comparateur à seuil, et un convertisseur charge / tension permettant de discriminer un niveau logique relatif au courant mesuré.

La figure 1B représente une vue en coupe d'une partie d'un dispositif de mémorisation de données 100 selon une seconde variante du premier mode de réalisation.

Dans cette variante, les moyens de mesure de courant 118, disposés au niveau du substrat 102, sont reliés à la micro-pointe 112. Les moyens de mesure de courant 118 peuvent être communs à l'ensemble des colonnes 110 adressées par une des micro-pointes 112, par exemple commun à l'ensemble des colonnes 110 se trouvant dans un même caisson 116.

Une opération d'écriture d'un bit dans un élément de mémorisation du dispositif 100 de la figure 1B va maintenant être décrite.

La colonne 110, dans laquelle le bit d'information doit par exemple être stocké, est sélectionnée en plaçant une des micro-pointes 112 en contact avec cette colonne 110. La micro-pointe 112 applique donc une tension, par exemple nulle, à une extrémité de la colonne 110. L'une des couches mémoires 106.1 à 106.3 dans laquelle on souhaite écrire un bit est ensuite sélectionnée par l'intermédiaire des moyens de sélection de couches mémoires. Lorsque l'on polarise, même transitoirement, par rapport à la micro-pointe 112, la couche mémoire considérée, un courant circule depuis ladite couche mémoire vers la colonne 110. La couche mémoire sert donc également d'électrode lors d'une opération de lecture ou d'écriture dans un élément de mémorisation du dispositif. Ce courant conduit à un échauffement par effet Joule qui est concentré dans le voisinage de la colonne 110, au niveau de la couche mémoire, car c'est à cet endroit que la densité de courant est la plus forte et que la surface d'échange thermique est la plus faible. Sur la couronne de cet interface, si la tension est suffisante, le matériau à changement de phase de la couche mémoire peut alors être porté à une température supérieure à sa température de fusion (par exemple 650°C pour une couche mémoire à base de GeSbTe) pour que, lors d'un refroidissement brutal, tel qu'un arrêt du passage du courant, le matériau à changement de phase, initialement à l'état cristallin, soit mis localement dans un état amorphe, peu conducteur. Un anneau de matériau amorphe est ainsi formé autour de la colonne 110 et constitue la forme physique du bit d'information. Le matériau à l'état amorphe étant moins conducteur, celui-ci va dorénavant limiter le passage de courant entre la micro-pointe 112 et la couche mémoire comportant le matériau à l'état amorphe.

L'information peut ensuite être relue par les moyens 118 de mesure du courant circulant depuis la micro-pointe 112 et/ou dans les niveaux mémoires 106. Pour cela, on polarise la couche mémoire concernée par rapport à la micro-pointe 112 à une tension suffisamment faible pour ne pas risquer de réchauffer le matériau au point de le faire (re)cristallisé. Il est alors possible de déduire du courant mesuré si un anneau de matériau amorphe est présent ou non autour de la colonne 110, au niveau de la couche mémoire sélectionnée.

L'état de conduction de la couche mémoire dépend de la taille de la zone amorphe. Ainsi, il est possible de coder les informations sous forme binaire ou sous forme de bit constitué de plusieurs niveaux (bit discretisé) dans une seule couche mémoire et autour d'une seule colonne 110, la taille possible de la zone amorphe dépendant de la puissance de l'effet joule lors de l'écriture (paramètre actif) et de la conductivité thermique du matériau des colonnes.

L'effacement d'une information au croisement d'une colonne 110 et d'une des couches mémoires 106.1 à 106.3 se fait avec un courant plus important et pendant un temps suffisant pour permettre le chauffage à la température de cristallisation et le retour du volume de matériau amorphe à l'état cristallin, en le portant à une température dite de « cristallisation », par exemple supérieure à environ 170°C pour le GeSbTe.

On peut optimiser le temps d'accès en lecture et en écriture du dispositif de mémorisation 100 en groupant les informations en mots de, par exemple, 8, 16 ou 32 bits, chaque mot étant écrit dans toutes les couches mémoires 106.1 à 106.3, au niveau d'une seule colonne 110. Le nombre de niveaux de mémorisation des colonnes, c'est-à-dire le nombre de couches mémoires que comporte le dispositif de mémorisation 100, peut donc être adapté en fonction de la taille souhaitée des mots d'informations écrits ou lus.

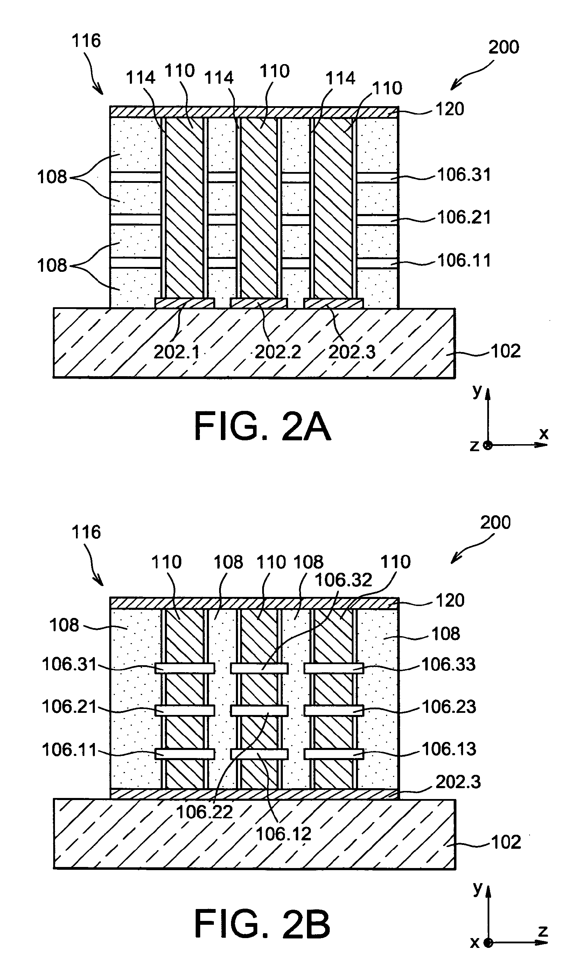

Un dispositif de mémorisation de données 200 selon un second mode de réalisation va maintenant être décrit en liaison avec les figures 2A et 2B.

Par rapport au dispositif 100 des figures 1A et 1B, chacune des couches mémoires du dispositif 200 est formée de plusieurs parties isolées les unes des autres par le matériau isolant des couches isolantes 108. Sur l'exemple des figures 2A et 2B, la couche mémoire 106.1 des figures 1A et 1B comporte les trois parties 106.11 à 106.13, la couche mémoire 106.2 comportant les trois parties 106.21 à 106.23 et la couche mémoire 106.3 comportant les trois parties 106.31 à 106.33. Chacune de ces parties de couche mémoire 106.11 à 106.33 a une forme sensiblement rectangulaire dans le plan (x,z).

Comme dans le dispositif 100 selon le premier mode de réalisation, le dispositif 200 mémorise des informations en changeant la phase du matériau des parties de couches mémoires 106.11 à 106.33, au niveau des colonnes 110. Dans l'exemple des figures 2A et 2B, un seul caisson 116 comportant neuf colonnes 110 est représenté.

Dans ce second mode de réalisation, les colonnes 110 ne sont pas repérées au moyens de micro-pointes mais par des lignes conductrices 202.1 à 202.3 disposées sur le substrat 102, sous les colonnes 110. Le caisson 116 représenté sur les figures 2A et 2B comporte trois lignes conductrices 202.1 à 202.3, chacune de ces lignes conductrices 202.1 à 202.3 étant en contact avec trois colonnes 110, chacune de ces trois colonnes 110 étant en contact avec trois parties distinctes de couches mémoires 106.11 à 106.33.

Ainsi, chaque point mémoire du dispositif 200 est localisé à la croisée d'une des parties de couches mémoires 106.11 à 106.33 sélectionnée et d'une des lignes conductrices 202.1 à 202.3 sélectionnée. La sélection de parties de couches mémoires 106.11 à 106.33 et de lignes conductrices 202.1 à 202.3 est réalisée par un circuit électronique de multiplexage, non représenté sur les figures 2A et 2B, intégré sur le substrat 102 du dispositif 200, par exemple réalisé en technologie CMOS. L'écriture, la lecture et l'effacement d'informations dans le dispositif 200 est réalisé par le même phénomène de changement de phase du matériau mémoire, en appliquant une tension entre une des parties de couches mémoires 106.11 à 106.33 et une des lignes conductrices 202.1 à 202.3.

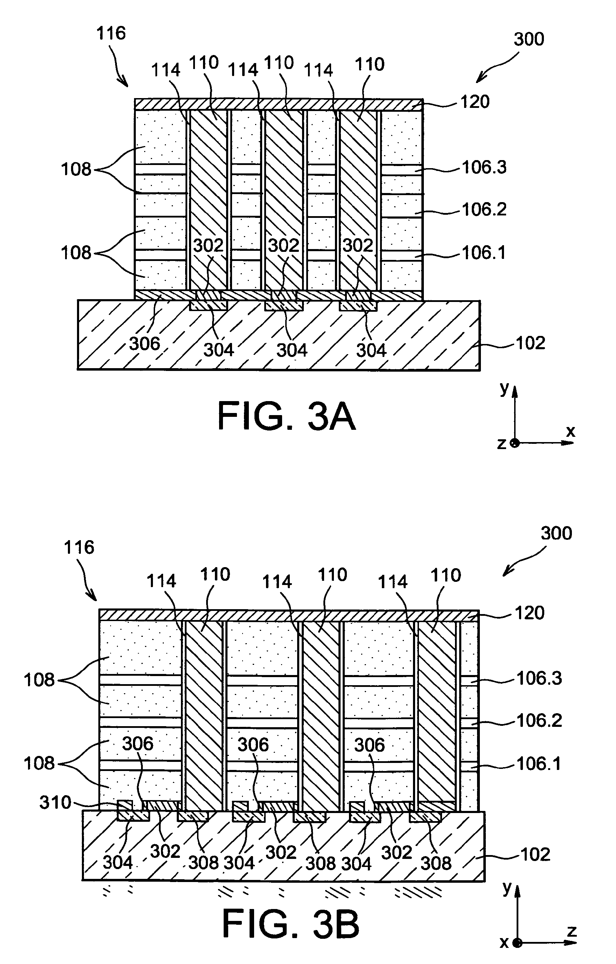

Un dispositif de mémorisation de données 300 selon un troisième mode de réalisation va maintenant être décrit en liaison avec les figures 3A et 3B.

Comme dans le premier mode de réalisation, le dispositif 300 comporte des couches mémoires 106.1 à 106.3 séparées les unes des autres par des couches isolantes 108.

Par rapport au premier mode de réalisation, le dispositif 300 ne comporte pas de micro-pointes pour réaliser l'adressage des colonnes 110. Dans ce troisième mode de réalisation, un transistor est présent « au pied » de chaque colonne 110. Les grilles 302 de transistors se trouvant sur une même ligne, comme représenté sur la figure 3A, sont reliées les unes aux autres par un conducteur de grille 306. Dans cet exemple de réalisation, dans chaque caisson 116 comportant trois lignes de trois colonnes 110, trois conducteurs de grilles sont présents. Chaque transistor comporte des zones de source 304 et de drain 308 réalisées dans le substrat 102. Comme représenté sur la figure 3B, chaque zone de drain 308 des transistors est en contact avec la colonne 110 adjacente au transistor. Enfin, des portions conductrices 310, perpendiculaires aux conducteurs de grilles 306, relient chaque zone de source 304 vers un circuit de multiplexage. Les portions conductrices représentées sur l'exemple de la figure 3B sont reliées les unes aux autres, formant un conducteur de ligne dans la direction orthogonale aux conducteurs de grilles 306.

Ainsi, les conducteurs de grille 306 et les conducteur de ligne forment une matrice permettant d'adresser une seule colonne, par exemple dans un caisson. Par un multiplexage des conducteurs de grille, on peut mettre en conduction tous les transistors d'une ligne considérée, en polarisant leur grille par une tension appliquée sur le conducteur de grille. Ensuite, par un multiplexage de conducteur de ligne, on peut alors sélectionner, dans la ligne de transistor polarisée, une colonne dans laquelle on souhaite écrire, lire ou effacer une information. Ces deux opérations de multiplexage peuvent être mises en oeuvre par un multiplexeur électronique, non représenté. Ce multiplexeur peut également servir à mettre en liaison le circuit de détection de courant, non représenté sur les figures 3A et 3B, qui permet de quantifier l'état de la mémoire lu.

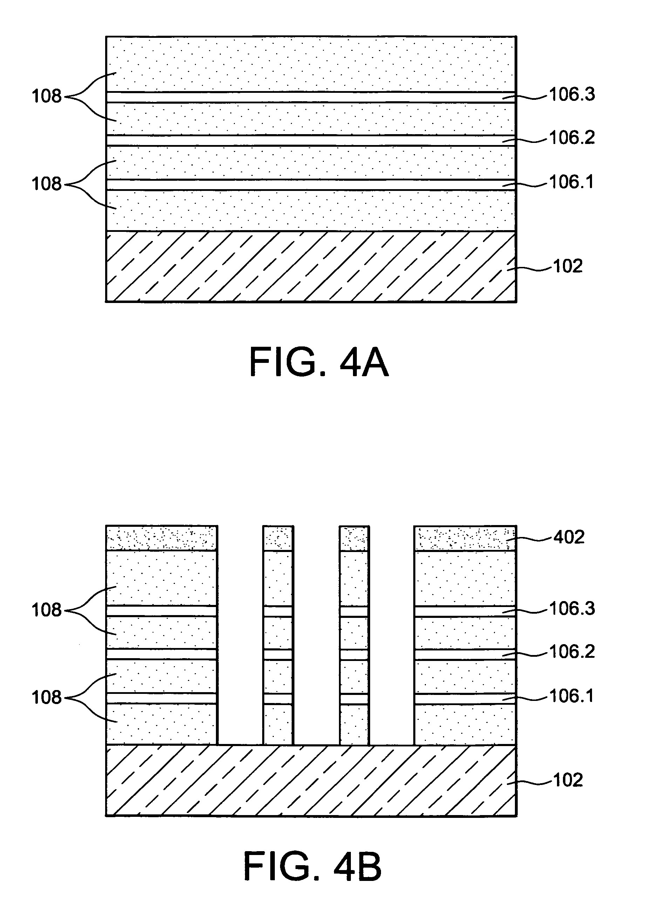

Un procédé de réalisation du dispositif de mémorisation va maintenant être décrit en liaison avec les figures 4A à 4E.

Comme représenté sur la figure 4A, on réalise tout d'abord, sur le substrat 102, un empilement formé des couches isolantes 108 et des couches mémoires 106.1 à 106.3. Ces couches isolantes 108 et ces couches mémoires 106.1 à 106.3 peuvent par exemple être réalisées par des dépôt successifs de même nature, telle que des dépôt PVD (dépôt physique en phase vapeur). Le substrat 102 peut également comporter, avant la réalisation de l'empilement, une couche technologique, comportant par exemple les moyens de mesure de courant 118 représentés sur les figures 1A et 1B et/ou les transistors d'adressage et/ou les conducteurs de grille 306 et/ou les conducteurs de ligne des figures 3A et 3B, et/ou les lignes conductrices 202.1 à 202.3 des figures 2A et 2B, en fonction du type du dispositif de mémorisation réalisé.

Il est possible de réaliser, entre une ou plusieurs étapes de dépôt d'une couche de l'empilement (isolante ou couche mémoire), un étape de planarisation mécano-chimique de la couche déposée.

Si le dispositif de mémorisation réalisé est par exemple similaire au dispositif 200 des figures 2A et 2B, alors le procédé comporte une étape supplémentaire de photolithographie et de gravure après chaque dépôt d'une couche mémoire, lors de la réalisation de l'empilement, afin de réaliser les parties isolées des couches mémoires représentées sur les figures 2A et 2B.

De préférence, la première couche et la dernière couche de l'empilement déposées sur le substrat 102 sont des couches isolantes 108.

On structure ensuite l'empilement en déposant un masque de lithographie 402 sur l'empilement, puis en réalisant une gravure, par exemple une gravure ionique réactive RIE, de l'empilement des couches isolantes 108 et des couches mémoires 106.1 à 106.3 (figure 4B). Cette étape de structuration permet de réaliser des trous, futurs emplacement des colonnes 110 du dispositif de mémorisation, et de structurer éventuellement le dispositif de mémorisation en caissons. Le masque 402 peut par exemple être une couche de résine photosensible, insolée au travers d'un masque ou une couche à base d'un matériau plastique et déformée par un procédé de moulage. Le masque 402 permet de transférer le motif définissant l'emplacement des colonnes dans l'empilement ainsi que la répartition des caissons dans l'empilement par un procédé de gravure, tel qu'une gravure ionique ou une gravure par ions réactifs.

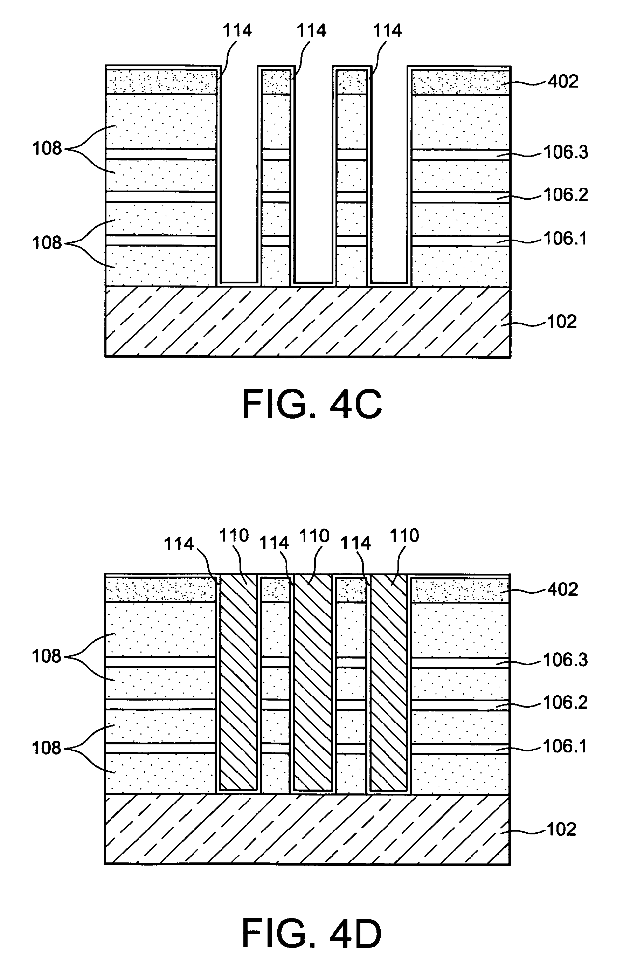

Comme représenté sur la figure 4C, on réalise les structures de diodes 114 destinées à être disposées autour des colonnes 110. Les jonctions de diodes 114 peuvent par exemple être réalisée par une structure Schottky avec un matériau semi-conducteur, tel que du silicium polycristallin, déposé par CVD (dépôt chimique en phase vapeur).

On réalise ensuite les colonnes 110 dans les trous réalisés précédemment, par exemple par dépôt électrochimique ou par croissance de nanotubes de carbone ou de nanofils de semi-conducteur à partir d'un catalyseur, permettant d'obtenir des colonnes 110 dont la dimension dans le sens de l'empilement soit grande par rapport aux dimensions dans le plan des couches de l'empilement, c'est-à-dire formant des colonnes longues et fines (figure 4D).

La réalisation de colonnes par croissance de nanotubes ou de nanofils permet notamment la réalisation d'une structure de diodes en série au sein même des colonnes en faisant croître successivement des couches dopées N et P. Dans le cas de colonnes réalisées par croissance de nanofils de silicium, une telle structure de diodes peut être obtenue en alternant les gaz interagissant lors de la croissance VLS (Vapeur-Liquide-Solide) en plus du silane utilisé, comme par exemple de l'arsine et de la phosphine, permettant de réaliser les dopages respectivement P et N.

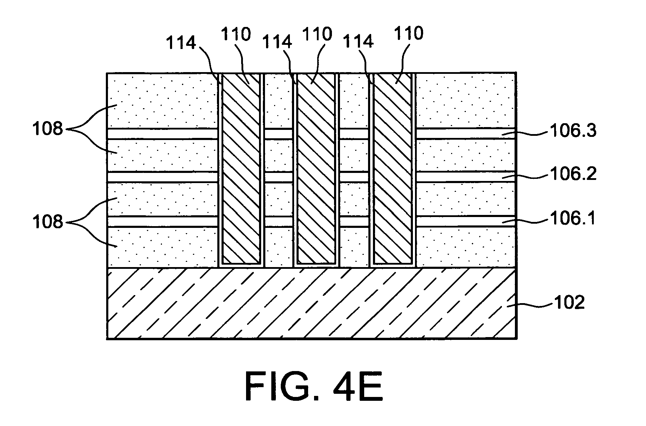

Comme représenté sur la figure 4E, on réalise ensuite, par exemple par un polissage mécano-chimique du dispositif, le retrait du masque 402 ainsi que des matériaux de dépôt des colonnes 110 et des structures de diodes 114 se trouvant sur le masque 402.

On termine ensuite le dispositif de mémorisation de données en déposant une couche de « tribologie », par exemple similaire à la couche 120 représentée sur les figures 1A et 1B par une pulvérisation de carbone comportant éventuellement des impuretés métalliques.

Dans le cas de la réalisation d'un dispositif de mémorisation sensiblement similaire à celui du premier mode de réalisation, la structure réalisée est ensuite couplée à des micro-pointes de type MEMS, utilisées pour l'adressage des colonnes.

Selon une variante de ce procédé de réalisation, il est possible de réaliser tout d'abord la croissance de nanofils de silicium, ou de nanotubes de carbone, sur le substrat 102, formant les colonnes 110. Lorsque le substrat 102 est à base de silicium d'orientation cristalline *(111)*, les nanofils obtenus par croissance sont orientés sensiblement perpendiculairement par rapport à la face du substrat 102 sur laquelle est réalisée la croissance. Lorsque le substrat 102 est à base de silicium d'orientation cristalline (100), les nanofils obtenus par croissance ne sont plus orientés sensiblement perpendiculairement à ladite face du substrat 102, ce qui permet par la suite d'obtenir par exemple des colonnes non perpendiculaires par rapport à ladite face du substrat 102. Ensuite, l'empilement des couches isolantes 108 et des couches mémoires 106.1 à 106.3 est réalisé autour des colonnes 110 par dépôts successifs et alternés de ces couches, par exemple par dépôt PVD (dépôt physique en phase vapeur) .

## Revendications

1. Dispositif (100, 200, 300) de mémorisation de données, comportant au moins :
- un empilement de couches comportant au moins une couche mémoire (106.1 à 106.3) à base d'un matériau à changement de phase disposée entre au moins deux couches isolantes (108), disposé sur un substrat (102),
- une pluralité de colonnes (110) disposées dans l'empilement de couches (106.1 à 106.3, 108), et traversant chaque couche de cet empilement, chacune des colonnes (110) étant à base d'au moins un matériau électriquement conducteur,
- une pluralité d'éléments de mémorisation formés par des portions annulaires de la couche mémoire (106.1 à 106.3) entourant les colonnes (110).

2. Dispositif (100, 200, 300) selon l'une des revendications précédentes, les couches isolantes (108) étant à base de silice et/ou de nitrure de silicium et/ou de sulfure de zinc.

3. Dispositif (100, 200, 300) selon l'une des revendications précédentes, le matériau à changement de phase étant de la famille des chalcogénures, tel que du GeSbTe et/ou de l'AgInSbTe.

4. Dispositif (100, 200, 300) selon l'une des revendications précédentes, les colonnes (110) étant à base d'au moins un métal tel que du Cu et/ou du TiN et/ou du W, et/ou d'un semi-conducteur, et/ou de nanotubes de carbone et/ou de nanofils de semi-conducteur tel que du silicium.

5. Dispositif (100, 200, 300) selon l'une des revendications précédentes, comportant en outre des diodes (114) disposées entre chaque couche mémoire (106.1 à 106.3) et chacune des colonnes (110).

6. Dispositif (100, 200, 300) selon l'une des revendications 1 à 4, comportant en outre des diodes disposées dans les colonnes (110), au niveau des couches isolantes (108).

7. Dispositif (100, 200, 300) selon l'une des revendications précédentes, l'empilement de couches étant formé par une alternance de couches isolantes (108) et de couches mémoires (106.1 à 106.3).

8. Dispositif (100, 200, 300) selon l'une des revendications précédentes, comportant en outre une pluralité de tranchées réalisées dans l'empilement et traversant toutes les couches (106.1 à 106.3, 108) de l'empilement, formant plusieurs portions (116), isolées les unes des autres, de l'empilement de couches (106.1 à 106.3, 108) et des colonnes (110).

9. Dispositif (200) selon l'une des revendications précédentes, chacune des couches mémoires (106.1 à 106.3) étant formée de plusieurs parties (106.11 à 106.33) isolées électriquement les unes des autres.

10. Dispositif (100, 200, 300) selon l'une des revendications précédentes, comportant en outre des moyens d'application de tension aux bornes des colonnes (110).

11. Dispositif (100) selon la revendication 10, les moyens d'application de tension aux bornes des colonnes (110) comportant un réseau de micro-pointes mobiles (112).

12. Dispositif (100, 200, 300) selon la revendication 11, comportant en outre au moins une couche (120) partiellement conductrice disposée sur l'empilement de couches (106.1 à 106.3, 108) et sur les sommets des colonnes (110).

13. Dispositif (200) selon l'une des revendications 10 à 12, les moyens d'application de tension aux bornes des colonnes (110) comportant un réseau de lignes conductrices (202.1 à 202.3) en contact avec les colonnes (110).

14. Dispositif (300) selon l'une des revendications 10 à 13, les moyens d'application de tension aux bornes des colonnes (110) comportant un réseau de transistors (302, 304, 306, 308, 310).

15. Dispositif (100, 200, 300) selon l'une des revendications 10 à 14, les moyens d'application de tension aux bornes des colonnes (110) comportant un circuit de multiplexage.

16. Dispositif (100, 200, 300) selon l'une des revendications précédentes, comportant en outre des moyens d'application de tension aux bornes des couches mémoires (106.1 à 106.3).

17. Dispositif (100, 200, 300) selon l'une des revendications précédentes, comportant en outre des moyens de sélection d'une ou plusieurs colonnes (110) et/ou des moyens de sélection d'une ou plusieurs couches mémoires (106.1 à 106.3).

18. Dispositif (100, 200, 300) selon la revendication 17, les moyens de sélection d'une ou plusieurs colonnes (110), et/ou les moyens de sélection d'une ou plusieurs couches mémoires (106.1 à 106.3) étant mis en oeuvre par un circuit électronique de multiplexage.

19. Dispositif (100, 200, 300) selon l'une des revendications précédentes, comportant en outre des moyens (118) de mesure de courant.

20. Dispositif (100, 200, 300) selon l'une des revendications précédentes, les moyens (118) de mesure de courant comportant des moyens logiques de sélection d'adresse tels qu'un multiplexeur et/ou au moins un amplificateur intégré et/ou un convertisseur courant / tension et/ou un comparateur à seuil et/ou un convertisseur charge / tension.

21. Procédé de réalisation d'un dispositif (100, 200, 300) de mémorisation de données, comportant au moins les étapes de :
- réalisation, sur un substrat (102), d'un empilement de couches comportant au moins une couche mémoire (106.1 à 106.3) à base d'un matériau à changement de phase disposée entre au moins deux couches isolantes (108),
- gravure d'une pluralité de trous dans l'empilement de couches (106.1 à 106.3, 108), les trous traversant chaque couche (106.1 à 106.3, 108) de l'empilement,
- réalisation de colonnes (110) à base d'au moins un matériau électriquement conducteur, dans les trous, tel qu'une pluralité d'éléments de mémorisation formés par des portions annulaires de la couche mémoire (106.1 à 106.3) entourent les colonnes (110).

22. Procédé de réalisation d'un dispositif (100, 200, 300) de mémorisation de données, comportant au moins les étapes de :
- réalisation, sur un substrat (102), de colonnes (110) à base d'au moins un matériau électriquement conducteur,
- réalisation d'un empilement de couches comportant au moins une couche mémoire (106.1 à 106.3) à base d'un matériau à changement de phase disposée entre au moins deux couches isolantes, sur le substrat (102), autour des colonnes (110), tel qu'une pluralité d'éléments de mémorisation formés par des portions annulaires de la couche mémoire (106.1 à 106.3) entourent les colonnes (110).

23. Procédé selon l'une des revendications 21 ou 22, le substrat (102) comportant un circuit intégré comprenant des moyens de mesure de courant (118) et/ou des moyens d'adressage des colonnes (110) et des couches mémoires (106.1 à 106.3) et/ou des moyens de multiplexage et/ou des moyens de sélection d'adresse.

24. Procédé selon l'une des revendications 21 à 23, la réalisation de l'empilement de couches (106.1 à 106.3, 108) étant obtenue par des étapes de dépôt alternées des couches isolantes (108) et des couches mémoires (106.1 à 106.3), une étape supplémentaire de photolithographie et de gravure étant mise en oeuvre après chaque dépôt d'une couche mémoire (106.1 à 106.3) pour former plusieurs parties (106.11 à 106.33), isolées électriquement les unes des autres, de cette couche mémoire (106.1 à 106.3).

25. Procédé selon l'une des revendications 21 à 24, comportant en outre, après l'étape de réalisation de l'empilement de couches (106.1 à 106.3, 108), une étape de réalisation d'une pluralité de tranchées dans l'empilement, traversant toutes les couches (106.1 à 106.3, 108) de l'empilement et formant plusieurs portions (116), isolées les unes des autres, de l'empilement de couches (106.1 à 106.3, 108).

26. Procédé selon l'une des revendications 21 à 25, comportant en outre une étape de réalisation de diodes (114), autour des colonnes (110), chaque diode (114) étant destinée à être disposée au niveau d'une couche mémoire (106.1 à 106.3).

27. Procédé selon l'une des revendications 21 à 25, comportant en outre une étape de réalisation de diodes, dans les colonnes (110), au niveau des couches isolantes (108).

28. Procédé selon l'une des revendications 21 à 27, la réalisation des colonnes (110) étant obtenue par dépôt électrochimique et/ou par croissance de nanotubes ou de nanofils à partir d'un catalyseur déposé au préalable sur le substrat (102).

29. Procédé selon l'une des revendications 21 à 28, comportant en outre une étape de dépôt d'une couche (120) au moins partiellement conductrice au moins sur les colonnes (110).

30. Procédé selon l'une des revendications 21 à 29, comportant en outre une étape de réalisation d'un réseau de micro-pointes mobiles (112) destinées à appliquer une tension aux bornes des colonnes (110).

## Claims

1. Data memorisation device (100, 200, 300) comprising at least:
- a stack of layers comprising at least one memory layer (106.1 to 106.3) based on a phase change material arranged between at least two insulating layers (108), placed on a substrate (102),
- a plurality of columns (110) arranged in the stack of layers (106.1 to 106.3, 108), and passing through each layer of this stack, each of the columns (110) being based on at least one electrically conducting material,
- a plurality of memorisation elements formed by annular portions of the memory layer (106.1 to 106.3) surrounding columns (110).

2. Device (100, 200, 300) according to one of the previous claims, the insulating layers (108) being based on silica and/or silicon nitride and/or zinc sulphide.

3. Device (100, 200, 300) according to one of the previous claims, the phase change material being of the chalcogenides family, such as GeSbTe and/or AgInSbTe.

4. Device (100, 200, 300) according to one of the previous claims, the columns (110) being based on at least a metal such as Cu and/or TiN and/or W, and/or a semiconductor, and/or carbon nanotubes and/or semiconductor nanowires such as silicon.

5. Device (100, 200, 300) according to one of the previous claims, also comprising diodes (114) arranged between each memory layer (106.1 to 106.3) and each column (110).

6. Device (100, 200, 300) according to one of claims 1 to 4, also comprising diodes arranged in the columns (110), at the insulating layers (108).

7. Device (100, 200, 300) according to one of the previous claims, the stack of layers being formed by an alternation of insulating layers (108) and memory layers (106.1 to 106.3).

8. Device (100, 200, 300) according to one of the previous claims, also comprising a plurality of trenches made in the stack and passing through all layers (106.1 to 106.3, 108) of the stack, forming several portions (116), isolated from each other, of the stack of layers (106.1 to 106.3, 108) and the columns (110).

9. Device (200) according to one of the previous claims, each of the memory layers (106.1 to 106.3) being formed of several parts (106.11 to 106.33) electrically isolated from each other.

10. Device (100, 200, 300) according to one of the previous claims, also comprising means for applying voltage at the terminals of the columns (110).

11. Device (100) according to claim 10, the means for applying voltage at the terminals of the columns (110) comprising a network of mobile microdots (112).

12. Device (100, 200, 300) according to claim 11, also comprising at least one partially conducting layer (120) arranged on the stack of layers (106.1 to 106.3, 108) and on the summits of the columns (110).

13. Device (200) according to one of the claims 10 to 12, the means for applying voltage at the terminals of the columns (110) comprising a network of conducting lines (202.1 to 202.3) in contact with the columns (110).

14. Device (300) according to one of claims 10 to 13, the means for applying voltage to the terminals of the columns (110) comprising a network of transistors (302, 304, 306, 308, 310).

15. Device (100, 200, 300) according to one of claims 10 to 14, the means for applying a voltage to the terminals of the columns (110) comprising a multiplexing circuit.

16. Device (100, 200, 300) according to one of the previous claims, also comprising means for applying voltage to the terminals of the memory layers (106.1 to 106.3).

17. Device (100, 200, 300) according to one of the previous claims, also comprising means for selecting one or several columns (110) and/or means for selecting one or several memory layers (106.1 to 106.3).

18. Device (100, 200, 300) according to claim 17, the means for selecting one or several columns (110), and/or means for selecting one or several memory layers (106.1 to 106.3) being used by a multiplexing electronic circuit.

19. Device (100, 200, 300) according to one of the previous claims, also comprising means (118) for measuring the current.

20. Device (100, 200, 300) according to one of the previous claims, the means (118) for measuring the current comprising logical means for address selection such as a multiplexer and/or at least one integrated amplifier and/or one current / voltage converter and/or a threshold comparator and/or a charge/voltage converter.

21. Method for making a data memorisation device (100, 200, 300) comprising at least the following steps:
- making a stack of layers comprising at least one memory layer(106.1 to 106.3) based on a phase change material arranged between at least two insulating layers (108) on a substrate (102),
- etching of a plurality of holes in the stack of layers (106.1 to 106.3, 108), the holes passing through each layer (106.1 to 106.3, 108) of the stack,
- producing the columns (110) based at least on an electrically conducting material, in the holes, such as a plurality of memorisation elements formed by annular portions of the memory layer (106.1 to 106.3) surround said columns (110).

22. Method for making a data memorisation device (100, 200, 300) comprising at least the following steps:
- producing columns (110) based on at least one electrically conducting material on a substrate (102),
- producing a stack of layers comprising at least one memory layer (106.1 to 106.3) based on a phase change material arranged between at least two insulating layers, on the substrate (102), around the columns (110), such as a plurality of memory elements formed by annular portions of the memory layer (106.1 to 106.3) surround said columns (110).

23. Method according to one of claims 21 or 22, the substrate (102) comprising an integrated circuit comprising current measurement means (118) and/or column addressing means (110) and memory layers (106.1 to 106.3) and or multiplexing means and/or address selection means.

24. Method according to one of claims 21 to 23, the stack of layers (106.1 to 106.3, 108) being obtained by alternating deposition steps of insulating layers (108) and memory layers (106.1 to 106.3), an additional photolithography and etching step being made after each deposition of a memory layer (106.1 to 106.3) to form several parts (106.11 to 106.33), electrically isolated from each other, from this memory layer (106.1 to 106.3).

25. Method according to one of claims 21 to 24, also comprising a step to make a plurality of trenches in the stack, passing through all layers (106.1 to 106.3, 108) of the stack and forming several portions (116), isolated from each other, of the stack of layers (106.1 to 106.3, 108), after the step for making the stack of layers (106.1 to 106.3, 108).

26. Method according to one of claims 21 to 25, also comprising a step for producing diodes (114), around the columns (110), each diode (114) being designed to be located at a memory layer (106.1 to 106.3).

27. Method according to one of claims 21 to 25, also comprising a step for producing diodes in the columns (110), at the insulating layers (108).

28. Method according to one of claims 21 to 27, the columns (110) being produced by electrochemical deposition and/or growth of nanotubes or nanowires starting from a catalyst previously deposited on the substrate (102).

29. Method according to one of claims 21 to 28, also comprising a step to deposit an at least partially conducting layer (120) at least on the columns (110).

30. Method according to one of claims 21 to 29, also comprising a step for producing a network of mobile microdots (112) designed to apply voltage at the terminals of the columns (110).

## Patentansprüche

1. Vorrichtung (100, 200, 300) zum Speichern von Daten, wobei die Vorrichtung wenigstens umfaßt:
- einen Schichtenstapel mit wenigstens einer Speicherschicht (106.1 bis 106.3) auf Basis eines Materials mit Phasenänderung, in Anordnung zwischen wenigstens zwei Isolierschichten (108), das Ganze in Anordnung auf einem Substrat (102),
- eine Mehrzahl von in dem Schichtstapel (106.1 bis 106.3, 108) angeordneten und jede Schicht des Stapels durchsetzenden Säulen bzw. Kolonnen (110), jede dieser Kolonnen (110) jeweils auf Basis eines elektrisch leitenden Materials,
- eine Mehrzahl von Speicherelementen in Form von jeweils die Kolonnen (110) umgebenden ringförmigen Bereichen der Speicherschicht (106.1 bis 106.3).

2. Vorrichtung (100, 200, 300) gemäß einem der vorhergehenden Ansprüche, bei welcher die Isolierschichten (108) auf Basis von Siliziumoxyd und/oder Siliziumnitrid und/oder Zinksulfid ausgebildet sind

3. Vorrichtung (100, 200, 300) nach einem der vorhergehenden Ansprüche, bei welcher das Material mit Phasenänderung aus der Familie der Chalcogenide wie beispielsweise GeSbTe und/oder AgInSbTe gewählt ist.

4. Vorrichtung (100, 200, 300) nach einem der vorhergehenden Ansprüche, bei welcher die Kolonnen (110) auf Basis wenigstens eines Metalls wie beispielsweise Cu und/oder TiN und/oder W, und/oder eines Halbleiters und/oder von Kohlenstoff-Nanoröhren und/oder Nanofäden aus einem Halbleiter wie beispielsweise Silizium ausgebildet sind.

5. Vorrichtung (100, 200, 300) nach einem der vorhergehen den Ansprüche, welche des weiteren Dioden (114) aufweist, die jeweils zwischen jeder Speicherschicht (106.1, bis 106.3) und jeder Kolonne (110) angeordnet sind.

6. Vorrichtung (100, 200, 300) nach einem der Ansprüche 1 bis 4, welche des weiteren Dioden aufweist, die in den Kolonnen (110), jeweils auf dem Niveau der Isolierschichten (108), angeordnet sind.

7. Vorrichtung (100, 200, 300) nach einem der vorhergehenden Ansprüche, bei welcher der Schichtstapel in Form einer Abwechslung zwischen Isolierschichten (108) und Speicherschichten (106.1 bis 106.3) ausgebildet ist.

8. Vorrichtung (100, 200, 300) nach einem der vorhergehenden Ansprüche, die des weiteren eine Mehrzahl von in dem Stapel vorgesehenen und jeweils jede der Schichten (106.1 bis 106.3, 108) des Stapels durchsetzenden Gräben aufweist, derart daß mehrere von einander isolierte Teilbereiche des Stapels aus Schichten (106.1 bis 106.3, 108) und Kolonnen (110) gebildet werden.

9. Vorrichtung (200) nach einem der vorhergehenden Ansprüche, bei welcher jeweils jede der Speicherschichten (106.1 bis 106.3) aus mehreren elektrisch von einander isolierten Teilen (106.11 bis 106.33) gebildet wird.

10. Vorrichtung (100, 200, 300) nach einem der vorhergehenden Ansprüche, welche des weiteren Mittel zum Anlegen von Spannung an die Anschlüsse der Kolonnen (110) umfaßt.

11. Vorrichtung (100) nach Anspruch 10, bei welcher die Mittel zur Spannungsbeaufschlagung an den Anschlüssen der Kolonnen (110) ein Netz-bzw. Gitterwerk beweglicher Mikrospitzen (112) aufweisen.

12. Vorrichtung (100, 200, 300) nach Anspruch 11, welche des weiteren wenigstens eine teilweise leitende Schicht (120) in Anordnung auf dem Schichtstapel (106.1 bis 106.3, 108) und auf den oberen Enden der Kolonnen (110) aufweist.

13. Vorrichtung (200) nach einem der Ansprüche 10 bis 12, bei welcher die Mittel zur Spannungsbeaufschlagung der Anschlüsse der Kolonnen (110) ein Netz- bzw. Gitterwerk elektrischer Leitungen (202.1 bis 202.3) in Kontakt mit den Kolonnen (110) umfaßt.

14. Vorrichtung (300) nach einem der Ansprüche 10 bis 13, bei welcher die Mittel zur Spannungsbeaufschlagung der Kolonnen (110) ein Netz von Transistoren (302, 304, 306, 308, 310) umfaßt.

15. Vorrichtung (100, 200, 300) nach einem der Ansprüche 10 bis 14, bei welcher die Mittel zur Spannungsbeaufschlagung der Anschlüsse der Kolonnen (110) eine Multiplexierschaltung umfassen.

16. Vorrichtung (130, 200, 300) nach einem der vorhergehenden Ansprüche, welche des weiteren Mittel zum Anlegen von Spannung an die Anschlüsse der Speicherschichten (106.1 bis 106.3) aufweist.

17. Vorrichtung (100, 200, 300) nach einem der vorhergehenden Ansprüche, welche des weiteren Mittel zur Auswahl einer oder mehrerer Kolonne(n) (110) und/ oder Mittel zur Auswahl einer oder mehrerer Speicherschicht(en) (106.1 bis 106.3) umfaßt.

18. Vorrichtung (100, 200, 300) nach Anspruch 17, bei welcher die Mittel zur Auswahl einer oder mehrerer Kolonne(n) (110) und/oder die Mittel zur Auswahl einer oder mehrerer Speicherschicht(en) (106.1 oder 106.3) mittels einer Multiplexierschaltung betätigbar sind.

19. Vorrichtung (100, 200, 300) nach einem der vorhergehenden Ansprüche, welche des weiteren Mittel (118) zur Strommessung umfaßt.

20. Vorrichtung (100, 200, 300) nach einem der vorhergehenden Ansprüche, bei welcher die Mittel (118) zur Strommessung logische Mittel zur Adressenwahl wie beispielsweise einen Multiplexer und/oder wenigstens einen integrierten Verstärker und/oder einen Strom/Spannungswandler und/oder einen Schwellwert-Komparator und/oder einen Ladungs/Spannungswandler aufweisen.

21. Verfahren zur Herstellung einer Vorrichtung (100, 200, 300) zur Speicherung von Daten, das Verfahren wenigstens umfassend die Verfahrens-stufen:
- Ausbilden, auf einem Substrat (102), eines Schichtenstapels, der wenigstens eine Speicherschicht (106.1 bis 106.3) auf Basis eines Materials mit Phasenänderung, in Anordnung zwischen wenigstens zwei Isolierschichten (108) aufweist,
- Ätzen einer Mehrzahl von Löchern bzw. Öffnungen in dem Schichtstapel (106.1 bis 106.3, 108), wobei diese Löcher bzw. Öffnungen jeweils jede Schicht (106.1 bis 106.3, 108) des Stapels durchsetzen,
- Ausbilden von Säulen bzw. Kolonnen (110) auf Basis wenigstens eines elektrisch leitenden Materials in den Löchern bzw. Öffnungen, derart daß beispielsweise eine Mehrzahl von Speicherelementen durch die Kolonnen (110) umgebende ringförmige Bereiche der Speicherschicht (106.1 bis 106.3) gebildet wird.

22. Verfahren zur Herstellung einer Vorrichtung (100, 200, 300) zum Speichern von Daten, das Verfahren umfassend wenigstens die Verfahrensstufen:
- Ausbilden, auf einem Substrat (102), von Säulen bzw. Kolonnen (110) auf Basis wenigstens eines elektrischen Leitermaterials,
- Ausbilden eines Schichtenstapels, der wenigstens eine Speicherschicht (106.1 bis 106.3) auf Basis eines Materials mit Phasenänderung in Anordnung zwischen wenigstens zwei Isolierschichten auf dem Substrat (102) um die Kolonnen (110) herum aufweist, derart daß eine Mehrzahl von Speicherelementen durch die Kolonnen (110) umgebende ringförmige Bereiche der Speicherschicht (106.1 bis 106.3) gebildet wird.

23. Verfahren nach einem der Ansprüche 21 oder 22, bei welchem das Substrat (102) eine integrierte Schaltung aufweist, welche Mittel (118) zur Strommessung und/oder Mittel zur Adressierung der Kolonnen (110) und der Speicherschichten (106.1 bis 106.3) und/oder Multiplexer-Mittel und/oder Mittel zur Addressenauswahl umfaßt.

24. Verfahren nach einem der Ansprüche 21 bis 23, bei welchem die Ausbildung des Schichtenstapels (106.1 bis 106.3, 108) erhalten wird durch Verfahrensstufen der alternierenden Abscheidung von Isolierschichten (108) und von Speicherschichten (106.1 bis 106.3) und eine zusätzliche Lichtdruck- und Ätz-Verfahrensstufe, die jeweils nach jeder Abscheidung einer Speicherschicht (106.1 bis 106.3) vorgenommen wird, zur Bildung mehrerer, elektrisch voneinander isolierter Teile (106.11 bis 106.33) dieser Speicherschicht (106.1 bis 106.3).

25. Verfahren nach einem der Ansprüche 21 bis 24, bei welchem des weiteren nach der Verfahrensstufe der Ausbildung des Schichtenstapels (106.1 bis 106.3, 108) eine Verfahrensstufe der Ausbildung einer Mehrzahl von Gräben in dem Schichtstapel vorgesehen ist, wobei die Gräben sämtliche Schichten (106,1 bis 106.3, 108) des Stapels durchsetzen, unter Bildung mehrerer voneinander isolierter Bereiche des Schichtenstapels (106.1 bis 106.3, 108).

26. Verfahren nach einem der Ansprüche 21 bis 25, welches des weiteren eine Verfahrensstufe derAusbildung von Dioden (114) um die Kolonnen (110) herum umfaßt, wobei jeweils jede Diode (114) bestimmungsgemäß auf dem Niveau einer Speicherschicht (106.1 bis 106.3) angeordnet ist.

27. Verfahren nach einem der Ansprüche 21 bis 25, welches des weiteren eine Verfahrensstufe der Ausbildung von Dioden in den Kolonnen (110) jeweils auf dem Niveau der Isolierschichten (108) umfaßt.

28. Verfahren nach einem der Ansprüche 21 bis 27, bei welchem die Ausbildung der Kolonnen (110) durch elektrochemische Abscheidung und/oder durch Aufwachsen von Nanoröhren oder von Nanofäden, ausgehend von einem zuvor auf dem Substrat (102) abgeschiedenen Katalysator erreicht wird.

29. Verfahren nach einem der Ansprüche 1 bis 28, welches des weiteren eine Verfahrensstufe der Abscheidung einer wenigstens teilweise leitenden Schicht (120) wenigstens auf den Kolonnen umfaßt.

30. Verfahren nach einem der Ansprüche 21 bis 29, weiches des weiteren eine Verfahrensstufe der Ausbildung eines Netzes bzw. Gitters beweglicher Mikrospitzen (112) umfaßt, welche bestimmungsgemäß zum Anlegen einer Spannung an die Kolonnen bzw. Säulen (110) dienen.
